# EUROPEAN PATENT APPLICATION

(11) **EP 1 148 388 A1**
(43) Date of publication of application: **24.10.2001**
(21) Application number: 01109594.0
(22) Date of filing: 18.04.2001
(51) Int. Cl.: G03F 7/039

(54) **Pattern formation material and pattern formation method**

(30) Priority: 19.04.2000 JP 2000117685
(71) Applicant: MATSUSHITA ELECTRIC INDUSTRIAL CO., LTD., Kadoma-shi, Osaka 571-8501 (JP)
(72) Inventor: Kishimura, Shinji, Itami-shi, Hyogo 664-0851 (JP); Sasago, Masaru, Hirakata-shi, Osaka 573-0007 (JP)
(74) Representative: Grünecker, Kinkeldey, Stockmair & Schwanhäusser Anwaltssozietät

(57) **Abstract**

A pattern formation material includes a base polymer. The base polymer includes a polymer of the acrylic family having a chlorine atom or a chlorinated alkyl group bonded to a carbon atom bonded to an ester site in the principal chain of an acrylic unit.

## Description

### BACKGROUND OF THE INVENTION

The present invention relates to method and material for forming a pattern, and more particularly, it relates to a method for forming a resist pattern, used for forming a semiconductor device or a semiconductor integrated circuit on a semiconductor substrate, by using exposing light of a wavelength of a 1 nm through 30 nm band or a 110 nm through 180 nm band and a pattern formation material used in the method.

Currently, in fabrication of a mass storage semiconductor integrated circuit, such as a 64 Mbit dynamic random access memory (RAM) and a logic device or a system LSI with a 0.25 *µ* m through 0.15 *µ* m rule, a resist pattern is formed by using a chemically amplified resist material including a polyhydroxystyrene derivative and an acid generator as principal constituents with KrF excimer laser (of a wavelength of a 248 nm band) used as exposing light.

Moreover, for fabrication of a 256 Mbit DRAM, a 1 Gbit DRAM or a system LSI with a 0.15 *µ*m through 0.13 *µ*m rule, a pattern formation method using, as exposing light, ArF excimer laser lasing at a shorter wavelength (of a 193 nm band) than the KrF excimer laser is now under development.

The resist material including a polyhydroxystyrene derivative as a principal constituent has high absorbance against light of a wavelength of a 193 nm band because of an aromatic ring included therein. Therefore, exposing light of a wavelength of a 193 nm band cannot uniformly reach the bottom of a resist film, and hence, a pattern cannot be formed in a good shape. Accordingly, the resist material including a polyhydroxystyrene derivative as a principal constituent cannot be used when the ArF excimer laser is used as the exposing light.

Therefore, a chemically amplified resist material including, as a principal constituent, a polyacrylic acid derivative having no aromatic ring is used when the ArF excimer laser is used as the exposing light.

On the other hand, as exposing light for a pattern formation method capable of coping with high resolution, X rays, an electron beam (EB) and the like are being examined.

When the X rays are used as the exposing light, however, there are a large number of problems in the exposure system and preparation of a mask. Also, when the EB is used as the exposing light, the throughput is disadvantageously low, and hence, the EB is not suitable to mass production. Thus, neither the X rays nor the EB is preferred as the exposing light.

Accordingly, in order to form a resist pattern finer than 0.10 *µ* m, it is necessary to use exposing light of a wavelength shorter than that of the ArF excimer laser, such as Xe₂ laser (of a wavelength of a 172 nm band), F₂ laser (of a wavelength of a 157 nm band), Kr₂ laser (of a wavelength of a 146 nm band), ArKr laser (of a wavelength of 134 nm band), Ar₂ laser (of a wavelength of a 126 nm band) and soft-X rays (of a wavelength of a 13, 11 or 5 nm band). In other words, a resist pattern is required to be formed by using exposing light of a wavelength of a 1 nm through 30 nm band or a 110 nm through 180 nm band.

Therefore, the present inventors have formed a resist pattern by conducting pattern exposure using F₂ laser (of a wavelength of a 157 nm band) on a resist film formed from a conventionally known chemically amplified resist material including a polyacrylic acid derivative represented by, for example, Chemical Formula 1 below.

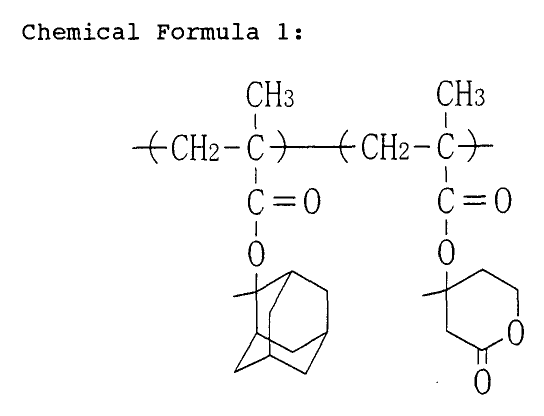

However, the resist pattern cannot be formed in a rectangular cross-sectional shape, and much scum remains on the semiconductor substrate. Such problems occur not only in using the F₂ laser as the exposing light but also in using another light of a wavelength of a 1 nm through 30 nm band or a 110 nm through 180 nm band.

Accordingly, a resist pattern cannot be practically formed by irradiating a resist film formed from a conventional chemically amplified resist material including a polyacrylic acid derivative with light of a wavelength of a 1 nm through 30 nm band or a 110 nm through 180 nm band.

### SUMMARY OF THE INVENTION

In consideration of the aforementioned conventional problems, an object of the invention is forming a resist pattern in a good pattern shape with minimally producing scum by using exposing light of a wavelength of a 1 nm through 30 nm band or a 110 nm through 180 nm band.

The present inventors have studied the causes of the conventional problems occurring in using the conventional resist material including a polyacrylic acid derivative as a principal constituent, and have found the following:

First, the resist material including a polyacrylic acid derivative has high absorbance against light of a wavelength of a 1nm through 180 nm band. For example, a resist film with a thickness of 100 nm formed from the resist material has transmittance of 20% at most against the F₂ laser (of a wavelength of a 157 nm band).

Therefore, various examination has been made on means for improving the transmittance of a resist material against light of a wavelength of a 1 nm through 180 nm band. As a result, the transmittance of a resist film against light of a wavelength of a 1 nm through 180 nm band can be improved by introducing a halogen element into a base polymer of the resist material.

Also, the present inventors have studied the cause of production of the scum. As a result, it has been found that when the resist material including a polyacrylic acid derivative as a principal constituent is irradiated with light of a wavelength of a 1 nm through 180 nm band, a hydrogen atom bonded to carbon located at the α-position of the principal chain of the base polymer is released so that polymer radicals from which the hydrogen atoms are released can be bonded to each other to be crosslinked. When the polymer radicals from which the hydrogen atoms are released are thus crosslinked, the solubility of an exposed portion of the resist film in a developer is degraded, resulting in producing the scum.

On the basis of the aforementioned findings, the present inventors have examined substitution of a fluorine atom for a carbon atom bonded to the ester site in the principal chain of a polyacrylic resin.

However, it has been found that the fluorine atom is released when irradiated with light of a wavelength of a 1 nm through 180 nm band and that polymer radicals from which the fluorine atoms are released are bonded to each other to be crosslinked, resulting in degrading the solubility of an exposed portion of the resist film in a developer.

Therefore, various examination has been made on means for preventing a crosslinking reaction of the principal chain of a base polymer regardless of introduction of a halogen element into the base polymer. As a result, it has been found that the crosslinking reaction can be avoided by allowing a chlorine atom or a chlorinated alkyl group to bond to a carbon atom bonded to the ester site in the principal chain of an acrylic unit.

The present invention was devised on the basis of the aforementioned findings, and specifically provides the following pattern formation materials and methods.

The first pattern formation material of this invention comprises a base polymer including a polymer of an acrylic family having a chlorine atom or a chlorinated alkyl group bonded to a carbon atom bonded to an ester site in a principal chain of an acrylic unit.

The second pattern formation material of this invention comprises a base polymer having a chlorine atom or a chlorinated alkyl group bonded to a carbon atom bonded to an ester site in a principal chain of an acrylic unit and a protecting group released by an acid; and an acid generator for generating an acid through irradiation with light.

In the first or second pattern formation material, a chlorine atom or a chlorinated alkyl group is introduced into the base polymer, and hence, a resist film formed from the pattern formation material is improved in transmittance against light of a wavelength of a 1 nm through 180 nm band. Accordingly, a resist pattern can be formed in a rectangular cross-sectional shape.

Furthermore, since a chlorine atom or a chlorinated alkyl group is bonded to a carbon atom bonded to the ester site in the principal chain of the acrylic unit, the chlorine atom or the chlorinate alkyl group is never released even when irradiated with light of a wavelength of a 1 nm through 180 nm band. Therefore, crosslinkage of polymer radicals can be avoided. Accordingly, the solubility in a developer of an exposed portion of the resist film can be prevented from degrading, and hence, no scum is produced on the substrate.

The first pattern formation method of this invention comprises the steps of forming a resist film by applying, on a substrate, a pattern formation material containing a base polymer including a polymer of an acrylic family having a chlorine atom or a chlorinated alkyl group bonded to a carbon atom bonded to an ester site in a principal chain of an acrylic unit; irradiating the resist film with exposing light of a wavelength of a 1 nm through 30 nm band or a 110 nm through 180 nm band for pattern exposure; and forming a resist pattern by developing the resist film after the pattern exposure.

The second pattern formation method of this invention comprises the steps of forming a resist film by applying, on a substrate, a pattern formation material including a base polymer having a chlorine atom or a chlorinated alkyl group bonded to a carbon atom bonded to an ester site in a principal chain of an acrylic unit and a protecting group released by an acid, and an acid generator for generating an acid through irradiation with light; irradiating the resist film with exposing light of a wavelength of a 1 nm through 30 nm band or a 110 nm through 180 nm band for pattern exposure; and forming a resist pattern by developing the resist film after the pattern exposure.

In the first or second pattern formation method, a chlorine atom or a chlorinated alkyl group is introduced into the base polymer, and hence, a resist film formed from the pattern formation material is improved in transmittance against light of a wavelength of a 1 nm through 30 nm band or a 110 nm through 180 nm band. Accordingly, a resist pattern can be formed in a rectangular cross-sectional shape.

Furthermore, since a chlorine atom or a chlorinated alkyl group is bonded to a carbon atom bonded to the ester site in the principal chain of the acrylic unit, the chlorine atom or the chlorinate alkyl group is never released even when irradiated with light of a wavelength of a 1 nm through 30 nm band or a 110 nm through 180 nm band. Therefore, crosslinkage of polymer radicals can be avoided. Accordingly, the solubility in a developer of an exposed portion of the resist film can be prevented from degrading, and hence, no scum is produced on the substrate.

In the first or second pattern formation method, the exposing light is preferably F₂ excimer laser, an Ar₂ excimer laser or soft-X rays.

### BRIEF DESCRIPTION OF THE DRAWINGS

FIGS. **1A, 1B** and **1C** are cross-sectional views for showing procedures in a pattern formation method according to Embodiment 1 of the invention; and
FIGS. **2A, 2B, 2C** and **2D** are cross-sectional views for showing procedures in a pattern formation method according to Embodiment 3 of the invention.

### DETAILED DESCRIPTION OF THE INVENTION

### EMBODIMENT 1

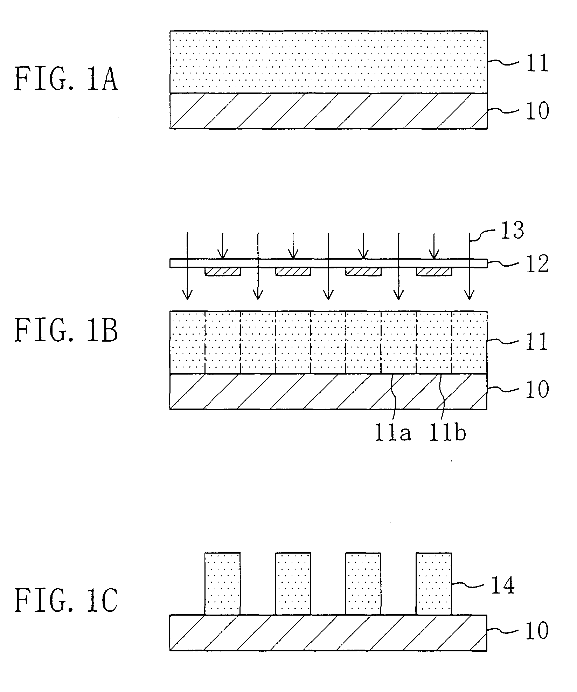

A pattern formation material and a pattern formation method according to Embodiment 1 of the invention will now be described with reference to FIGS. **1A** through **1C.**

A resist material of Embodiment 1 is a resist material not chemically amplified (hereinafter referred to as a non-chemically amplified resist material) including, as a base polymer, a polymer of the acrylic family having a chlorinated alkyl group (CCl₃) bonded to a carbon atom bonded to the ester site in the principal chain of an acrylic unit.

The specific composition of the resist material of this embodiment is as follows:
Base polymer: a polymer represented by Chemical Formula 2 below
Solvent: diglime

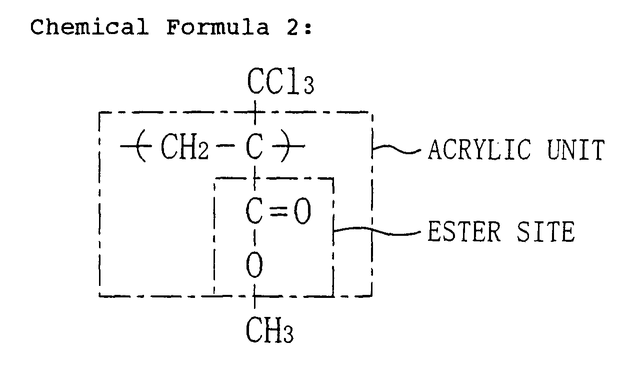

First, as is shown in FIG. **1A,** the resist material having the aforementioned composition is applied on a semiconductor substrate **10** by spin coating, so as to form a resist film **11** with a thickness of 0.2 *µ*m. At this point, since the base polymer is refractory in a developer of methylisobutyl ketone and isopropyl alcohol in a ratio of 1:3, the resist film **11** is refractory in the developer.

Next, as is shown in FIG. **1B,** the resist film **11** is irradiated through a mask **12** with a F₂ excimer laser beam **13** (of a wavelength of a 157 nm band) for pattern exposure. Thus, the base polymer is decomposed by the F₂ excimer laser beam **13** in an exposed portion **11a** of the resist film **11,** and hence, the exposed portion **11a** becomes soluble in the developer while an unexposed portion **11b** of the resist film **11** remains refractory in the developer.

Then, the resist film **11** is developed by using the developer of methylisobutyl ketone and isopropyl alcohol in a ratio of 1:3. Thus, the exposed portion **11a** of the resist film **11** is dissolved in the developer, so that a resist pattern **14** can be formed from the unexposed portion **11b** of the resist film **11** as is shown in FIG. **1C.**

### EMBODIMENT 2

A pattern formation material and a pattern formation method according to Embodiment 2 of the invention will now be described. Embodiment 2 is different from Embodiment 1 in the resist material alone, and hence, the resist material alone will be herein described.

The resist material of this embodiment is a non-chemically amplified resist material including, as a base polymer, a polymer of the acrylic family having a chlorine atom bonded to a carbon atom bonded to the ester site in the principal chain of an acrylic unit.

The specific composition of the resist material of Embodiment 2 is as follows:
Base polymer: a polymer represented by Chemical Formula 3 below
Solvent: diglime

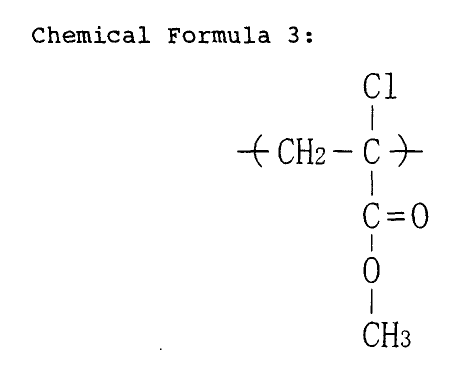

### EMBODIMENT 3

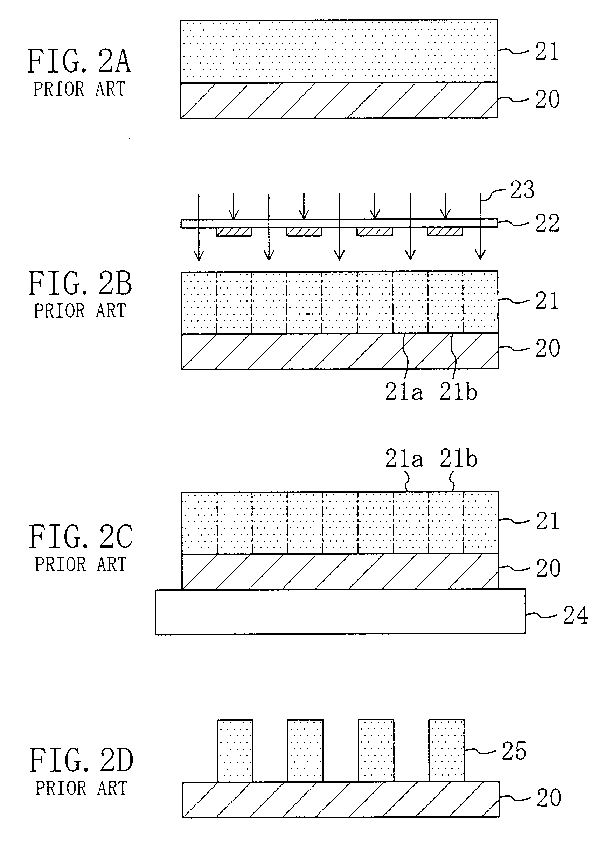

A pattern formation material and a pattern formation method according to Embodiment 3 of the invention will now be described with reference to FIGS. **2A** through **2D.**

The resist material of this embodiment is a non-chemically amplified resist material including, as a base polymer, a polymer of the acrylic family having a chlorinated alkyl group (CCl₃) bonded to a carbon atom bonded to the ester site in the principal chain of an acrylic unit.

The specific composition of the resist material of this embodiment is as follows:
Base polymer: a polymer represented by Chemical Formula 4 below
Acid generator: triphenylsulfonium triflate (1 wt% based on the base polymer)
Solvent: diglime

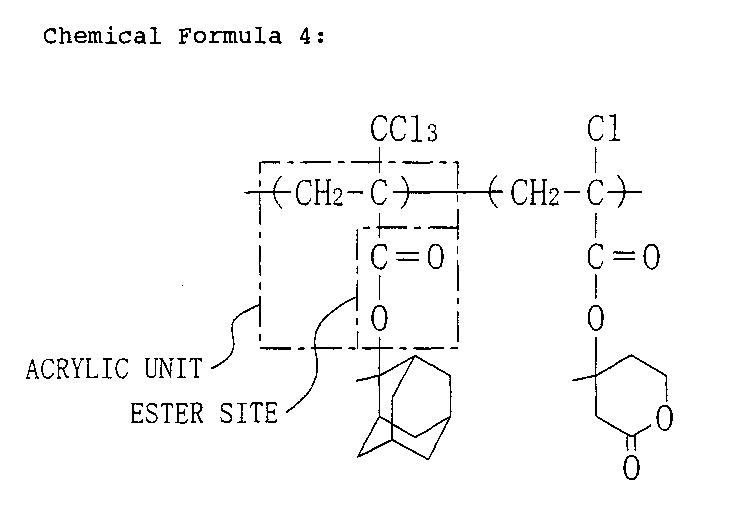

First, as is shown in FIG. 2A, the resist material having the aforementioned composition is applied on a semiconductor substrate 20 by spin coating, so as to form a resist film 21 with a thickness of 0.2 *µ* m. At this point, since the base polymer is alkali-refractory, the resist film 21 is alkali-refractory.

Next, as is shown in FIG. **2B,** the resist film **21** is irradiated through a mask **22** with a F₂ excimer laser beam **23** (of a wavelength of a 157 nm band) for pattern exposure. Thus, the acid generator is decomposed by the F₂ excimer laser beam **23** so as to generate an acid in an exposed portion **21a** of the resist film **21** while an unexposed portion **21b** of the resist film **21** remains refractory in an alkaline developer.

Then, as is shown in FIG. 2C, the semiconductor substrate **20** together with the resist film **21** is heated with a hot plate **24.** Thus, the base polymer is decomposed by the acid generated from the acid generator in the exposed portion **21a** of the resist film **21**, and hence, the exposed portion **21a** becomes soluble in an alkaline developer.

Subsequently, the resist film **21** is developed with an alkaline developer such as a tetramethylammonium hydroxide aqueous solution. Thus, the exposed portion **21a** of the resist film **21** is dissolved in the developer, so that a resist pattern **25** can be formed from the unexposed portion **21b** of the resist film **21** as is shown in FIG. **2D.**

### EMBODIMENT 4

A pattern formation material and a pattern formation method according to Embodiment 4 of the invention will now be described. Embodiment 4 is different from Embodiment 3 in the resist material alone, and hence, the resist material alone will be herein described.

The resist material of this embodiment is a non-chemically amplified resist material including, as a base polymer, a polymer of the acrylic family having a chlorine atom bonded to a carbon atom bonded to the ester site in the principal chain of an acrylic unit.

The specific composition of the resist material of Embodiment 4 is as follows:
Base polymer: a polymer represented by Chemical Formula 5 below
Acid generator: triphenylsulfonium triflate (1 wt% based on the base polymer)
Solvent: diglime

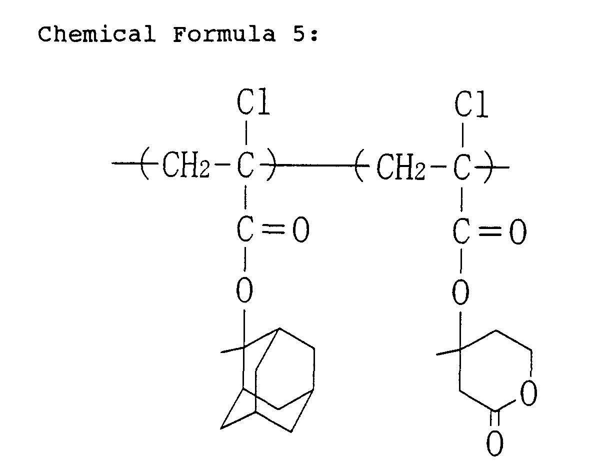

Although the chlorinated alkyl group bonded to the carbon atom is CCl₃ in Embodiment 1 or 3, CH₂Cl, CHCl₂, CCl₂CCl₃, CCl₂CH₃ or the like can be used instead.

Although the F₂ laser beam is used as the exposing light in any of Embodiments 1 through 4, a Xe₂ laser beam, a Kr₂ laser beam, an ArKr laser beam, an Ar₂ laser beam, soft-X rays or the like can be used instead.

## Claims

1. A pattern formation material comprising:
a base polymer including a polymer of an acrylic family having a chlorine atom or a chlorinated alkyl group bonded to a carbon atom bonded to an ester site in a principal chain of an acrylic unit.

2. A pattern formation material comprising:
a base polymer having a chlorine atom or a chlorinated alkyl group bonded to a carbon atom bonded to an ester site in a principal chain of an acrylic unit, and a protecting group released by an acid; and
an acid generator for generating an acid through irradiation with light.

3. A pattern formation method comprising the steps of:
forming a resist film by applying, on a substrate, a pattern formation material containing a base polymer including a polymer of an acrylic family having a chlorine atom or a chlorinated alkyl group bonded to a carbon atom bonded to an ester site in a principal chain of an acrylic unit;
irradiating said resist film with exposing light of a wavelength of a 1 nm through 30 nm band or a 110 nm through 180 nm band for pattern exposure; and
forming a resist pattern by developing said resist film after the pattern exposure.

4. The pattern formation method of Claim 3,
wherein said exposing light is F₂ excimer laser, an Ar₂ excimer laser or soft-X rays.

5. A pattern formation method comprising the steps of:
forming a resist film by applying, on a substrate, a pattern formation material including a base polymer having a chlorine atom or a chlorinated alkyl group bonded to a carbon atom bonded to an ester site in a principal chain of an acrylic unit and a protecting group released by an acid, and an acid generator for generating an acid through irradiation with light;
irradiating said resist film with exposing light of a wavelength of a 1 nm through 30 nm band or a 110 nm through 180 nm band for pattern exposure; and
forming a resist pattern by developing said resist film after the pattern exposure.

6. The pattern formation method of Claim 5,
wherein said exposing light is F₂ excimer laser, an Ar₂ excimer laser or soft-X rays.
